# EUROPÄISCHE PATENTSCHRIFT

(11) **EP 3 529 832 B1**
(45) Veröffentlichungstag und Bekanntmachung des Hinweises auf die Patenterteilung: **25.08.2021**
(21) Anmeldenummer: 17771366.6
(22) Anmeldetag: 11.09.2017
(51) Int. Cl.: H01L 23/373, H01L 23/14, H01L 23/498

(54) **LEISTUNGSMODUL**
POWER MODULE
MODULE DE PUISSANCE

(30) Priorität: 20.10.2016 DE 102016220553
(43) Veröffentlichungstag der Anmeldung: 28.08.2019
(73) Patentinhaber: Robert Bosch GmbH, 70442 Stuttgart (DE)
(72) Erfinder: SCHELLING, Guenter, 72116 Moessingen (DE); KIENLE, Wolfram, 71106 Magstadt (DE); HOMOTH, Jan, 72770 Reutlingen (DE)
(86) Internationale Anmeldenummer: PCT/EP2017/072737
(87) Internationale Veröffentlichungsnummer: WO 2018/072925

(56) Entgegenhaltungen:
- EP-A1- 1 909 324
- EP-A2- 2 006 910
- DE-A1-102007 041 921
- DE-A1-102014 206 608
- US-A- 6 060 150

## Beschreibung

### Stand der Technik

Die Erfindung betrifft ein Leistungsmodul mit den Merkmalen des Oberbegriffs des unabhängigen Anspruchs 1.

In Hybridfahrzeugen oder Elektrofahrzeugen werden Inverterstrukturen und Konverterstrukturen mit Kommutierungskreisen aus Zwischenkreiskondensatoren und Halbbrücken, die beispielsweise in Leistungsmodulen ausgebildet sind, eingesetzt. Beispielsweise werden zum Betreiben einer elektrischen Maschine Inverter verwendet, die Phasenströme für die elektrische Maschine bereitstellen. Die Inverter und Konverter umfassen beispielsweise Leistungsmodule. Die Leistungsmodule können beispielsweise ein Trägersubstrat mit Leiterbahnabschnitten umfassen, auf dem beispielsweise Leistungsschalter angeordnet sind, die zusammen mit dem Trägersubstrat ein Leistungsmodul bilden.

Das Trägersubstrat ist dabei häufig beispielsweise ein DBC-Substrat (Direct Bonded Copper), ein AMB-Substrat (Active Metal Brazed) oder ein IMS- Substrat (Insulated Metal Substrate). Bei der Herstellung beispielsweise eines DBC-Substrats werden Kupferfolien beispielsweise auf ein Keramiksubstrat aufgeschmolzen und die auf dem Keramiksubstrat aufgebrachte metallische Schicht aus Kupfer anschließend beispielsweise durch fotolithografische Prozesse in Leiterbahnabschnitte untergliedert. Auf der von der in Leiterbahnabschnitte untergliederten metallischen Schicht abgewandten Seite des Keramiksubstrats kann eine weitere metallische Schicht beispielsweise aus Kupfer ausgebildet sein. Diese weitere metallische Schicht aus Kupfer wird in Leistungselektronikanwendungen beispielsweise unter Zwischenlage einer elektrisch isolierenden Zwischenschicht auf einen Kühlkörper auflaminiert.

US 6060150 und EP 1909324 offenbaren ein Leistungsmodul umfassend einen Kühlkörper, eine Zwischenschicht und einen Leiterbahnabschnitt.

### Offenbarung der Erfindung

Erfindungsgemäß wird ein Leistungsmodul, umfassend wenigstens drei übereinander gestapelte Lagen vorgeschlagen. Die drei Lagen umfassen wenigstens einen Kühlkörper mit einer Oberseite, wenigstens eine auf die Oberseite des Kühlkörpers aufgebrachte und sich flächig erstreckende haftvermittelnde Zwischenschicht mit einer der Oberseite des Kühlkörpers zugewandten ersten Seite und einer von der ersten Seite abgewandten zweiten Seite und wenigstens eine auf der zweiten Seite der Zwischenschicht angeordnete und in Leiterbahnabschnitte untergliederte metallische Schicht mit einer Kontaktseite, die der zweiten Seite des Zwischenschicht zugewandt ist. Das Leistungsmodul umfasst weiterhin wenigstens ein elektrische und/oder elektronisches Leistungsbauelement, das auf wenigstens einen Leiterbahnabschnitt der metallischen Schicht aufgebracht ist und elektrisch mit dem wenigstens einen Leiterbahnabschnitt der metallischen Schicht elektrisch kontaktiert ist. Erfindungsgemäß ist die in Leiterbahnabschnitte untergliederte metallische Schicht unabhängig von der Herstellung der Zwischenschicht und unabhängig von der Herstellung des Kühlkörpers aus wenigstens einem in Leiterbahnabschnitte untergliederten Metallblech hergestellt. Erfindungsgemäß ist die erste Seite der Zwischenschicht auf die Oberseite des Kühlkörpers laminiert und die zweite Seite der Zwischenschicht auf die Kontaktseite der metallischen Schicht laminiert. Erfindungsgemäß ist die Zwischenschicht als Laminierfolie aus Kunststoff ausgebildet.

Erfindungsgemäß wird ein Verfahren zur Herstellung eines Leistungsmoduls nach einem der Ansprüche 1 bis 6 vorgeschlagen.

### Vorteile der Erfindung

Im Unterschied zum Stand der Technik kann bei dem Leistungsmodul die metallische Schicht bereits vor der Aufbringung der metallischen Schicht auf die Oberseite des Kühlkörpers in Leiterbahnabschnitte gegliedert werden. Die bereits bereitgestellten Leiterbahnabschnitte können dann vorteilhaft einfach unter Zwischenlage der Zwischenschicht auf die Oberseite des Kühlkörpers aufgebracht, beispielsweise auflaminiert werden, ohne dass anschließend eine weitere Verarbeitung der Leiterbahnabschnitte notwendig ist. Somit stellt das erfindungsgemäße Leistungsmodul im Vergleich zum Stand der Technik einen besonders einfachen Aufbau dar, der einfach und kostengünstig gefertigt werden kann. Zur Fertigung des erfindungsgemäßen Leistungsmoduls können vorteilhaft einfache Standardprozesse verwendet werden, wodurch das Leistungsmodul besonders einfach und kostengünstig gefertigt werden kann. Aufwändige und teure Prozesse beispielsweise zum Verschmelzen von Kupfer mit einem Keramiksubstrat und die anschließende Untergliederung der metallischen Schicht aus Kupfer beispielsweise durch fotolithografische Verfahren wie im Stand der Technik sind nicht nötig.

Weiterhin können, dadurch, dass die in Leiterbahnabschnitte untergliederte metallische Schicht unabhängig von der Herstellung der Zwischenschicht und der Herstellung des Kühlkörpers aus wenigstens einem in Leiterbahnabschnitte untergliederten Metallblech hergestellt wird, die Dicke des Metallblechs und somit die Dicke der Leiterbahnabschnitte vorteilhaft variiert werden und somit vorteilhaft die Verlustleistung der Leiterbahnabschnitte variiert werden. Es können beispielsweise vorteilhaft auch Teile der Leiterbahnabschnitte gebogen ausgeführt sein. So können beispielsweise Anschlussbereiche der Leiterbahnabschnitte, die zum Kontaktieren des Leistungsmoduls mit außerhalb des Leistungsmoduls vorgesehenen weiteren Komponenten vorgesehen sind, gebogen ausgeführt werden.

Weiterhin können im erfindungsgemäßen Leistungsmodul die Leiterbahnabschnitte durch ihre räumliche Nähe zu dem Kühlkörper, nur getrennt durch die Zwischenschicht, besonders gut gekühlt werden. Erfindungsgemäß ist die erste Seite der Zwischenschicht auf die Oberseite des Kühlkörpers laminiert und die zweite Seite der Zwischenschicht auf die Kontaktseite der metallischen Schicht laminiert. Damit ist die Zwischenschicht als Laminierfolie aus Kunststoff ausgebildet. Somit können die Leiterbahnabschnitte vorteilhaft einfach und sicher auf der Oberseite des Kühlkörpers befestigt werden und die Laminierfolie kann die Leiterbahnabschnitte vorteilhaft elektrisch von dem Kühlkörper isolieren.

Weitere vorteilhafte Ausgestaltungen und Weiterbildungen der Erfindungen werden durch die in den Unteransprüchen angegebenen Merkmale ermöglicht.

Besonders vorteilhaft haftet die erste Seite der Zwischenschicht stoffschlüssig an der Kontaktseite der metallischen Schicht an und/oder es haftet die zweite Seite der Zwischenschicht stoffschlüssig an der Oberseite des Kühlkörpers an. Eine derartige Zwischenschicht verbindet die metallische Schicht vorteilhaft gut und stabil mit dem Kühlkörper.

In einem besonders vorteilhaftem Ausführungsbeispiel sind die Leiterbahnabschnitte als Stanzteile ausgebildet. Als Stanzteile ausgebildete Leiterbahnabschnitte können vorteilhaft einfach beispielsweise aus einem oder mehreren Metallblechen gefertigt werden.

Es erweist sich als Vorteil, wenn der Leiterbahnabschnitt zumindest einen Anschlussbereich zur elektrischen Kontaktierung des Leiterbahnabschnitts aufweist, wobei der Anschlussbereich außerhalb einer Erstreckungsebene der metallischen Schicht angeordnet ist, in der sich die metallische Schicht im Wesentlichen erstreckt. Durch einen außerhalb der Erstreckungsebene der metallischen Schicht angeordneten Anschlussbereich kann das Leistungsmodul vorteilhaft einfach und gut und direkt ohne Zwischenelemente mit außerhalb des Leistungsmoduls angeordneten Bauelementen elektrisch kontaktiert werden. So kann der Anschlussbereich beispielsweise entfernt von der Erstreckungsebene der metallischen Schicht angeordnet sein und somit die metallische Schicht in der Erstreckungsebene und beispielsweise auch die Zwischenschicht vorteilhaft vor den Verbindungstechniken, beispielsweise Schweißen, zur Kontaktierung der Anschlussbereiche mit außerhalb des Leistungsmoduls angeordneten Bauelementen, geschützt sein.

Besonders vorteilhaft kann dabei der Anschlussbereich des Leiterbahnabschnittes aus der Erstreckungsebene des Leiterbahnabschnitts herausgebogen sein. Somit können die Leiterbahnabschnitte beispielsweise vorteilhaft einfach als Stanz-Biegeteile aus einem oder mehreren Metallblechen geformt sein.

Besonders vorteilhaft ist die Zwischenschicht einstückig ausgebildet ist und die Zwischenschicht liegt mit der ersten Seite direkt an der Oberseite des Kühlkörpers an und die Zwischenschicht liegt mit der zweiten Seite direkt an der Kontaktseite der metallischen Schicht an.

Weiterhin vorteilhaft ist ein Verfahren zur Herstellung eines Leistungsmoduls wobei das Verfahren einen Schritt zur Herstellung einer in Leiterbahnabschnitte untergliederten metallischen Schicht aus wenigstens einem Metallblech,
einen Schritt zum Aufbringen der in Leiterbahnabschnitte untergliederten metallischen Schicht unter Zwischenlage einer haftvermittelnden Zwischenschicht auf die Oberseite des Kühlkörpers, einen Schritt zum Auflaminieren der in Leiterbahnabschnitte untergliederten metallischen Schicht unter Zwischenlage der haftvermittelnden Zwischenschicht auf den Kühlkörper, einen Schritt zum Aufbringen wenigstens eines elektronischen Leistungsbauelement auf wenigstens einen Leiterbahnabschnitt der metallischen Schicht und einen Schritt zur elektrischen Kontaktierung des elektronischen Leistungsbauelement mit dem wenigstens einen Leiterbahnabschnitt der metallischen Schicht umfasst.

### Kurze Beschreibung der Zeichnungen

Ein Ausführungsbeispiel der Erfindung ist in der Zeichnung dargestellt und wird in der nachfolgenden Beschreibung näher erläutert. Es zeigen
Fig. 1 eine schematische Darstellung eines Ausführungsbeispiels des erfindungsgemäßen Leistungsmoduls,
Fig. 2 eine vergrößerte Darstellung des in Fig.1 dargestellten Ausführungsbeispiels des Leistungsmoduls.

### Ausführungsformen der Erfindung

Das erfindungsgemäße Leistungsmodul 1 kann vielfältige Anwendung finden, beispielsweise als Inverter oder Konverter in der Kraftfahrzeugtechnik. Beispielsweise kann die elektronische Schaltungseinheit als auch als Wechselrichter bezeichneter Inverter für den Betrieb einer elektrischen Maschine beispielsweise von Hybrid- oder Elektrofahrzeugen eingesetzt werden.

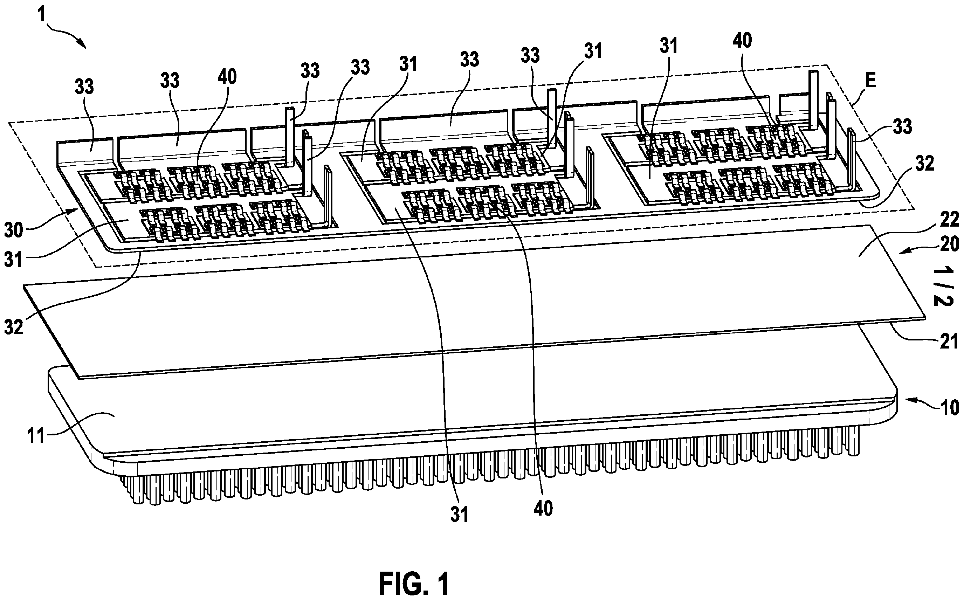

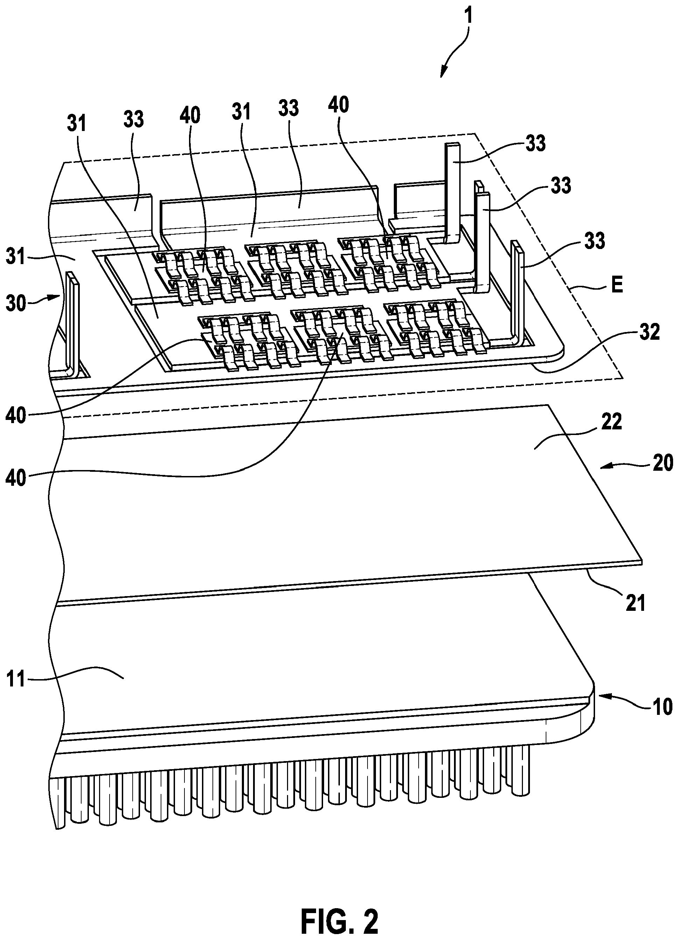

In Fig. 1 und Fig. 2 sind unterschiedliche Ansichten eines Ausführungsbeispiels der erfindungsgemäßen Leistungsmoduls 1 als Explosionsdarstellung dargestellt. Das Leistungsmodul 1 umfasst in diesem Ausführungsbeispiel drei übereinander gestapelte Lagen, die zusammen ein Trägersubstrat für elektrische und/oder elektronische Leistungsbauelemente 40 bilden können.

Das Leistungsmodul 1 umfasst eine Lage mit einem Kühlkörper 10 mit einer Oberseite 11. Der Kühlkörper 10 ist aus einem Material mit guter Wärmeleitfähigkeit wie beispielsweise Aluminium oder Kupfer gefertigt. Der Kühlkörper 10 ist in diesem Ausführungsbeispiel im Wesentlichen als Kühlplatte mit einer ebenen Oberseite 11 ausgebildet. An der von der Oberseite 11 des Kühlkörpers 10 abgewandten Seite des Kühlkörpers 10 sind beispielsweise Strukturen zur Verbesserung der Wärmeableitung ausgebildet. Als Strukturen zur Verbesserung der Wärmeableitung können beispielsweise Rippen, Stifte oder Kanäle, ausgebildet sein. In diesem Ausführungsbeispiel sind als Strukturen zur Verbesserung der Wärmeableitung an der von der Oberseite 11 des Kühlkörpers 10 abgewandten Seite Stifte an dem Kühlkörper 10 ausgebildet. Die Oberseite 11 des Kühlkörpers 10 ist in diesem Ausführungsbeispiel eine ebene Fläche. Der Kühlkörper 10 weist in diesem Ausführungsbeispiel in einer Richtung senkrecht zu der Oberseite 11 des Kühlkörpers 10 eine Dicke auf, die sowohl größer ist als eine Dicke der Zwischenschicht 20 in derselben Richtung als auch größer ist als eine Dicke der metallischen Schicht 30 in derselben Richtung.

Das Leistungsmodul 1 umfasst weiterhin eine Lage mit einer haftvermittelnden Zwischenschicht 20 mit einer ersten Seite 21 und einer von der ersten Seite 21 abgewandten zweiten Seite 22. Die haftvermittelnde Zwischenschicht 20 ist auf die Oberseite 11 des Kühlkörpers 10 aufgebracht und erstreckt sich in diesem Ausgangsbeispiel flächig auf der Oberseite 11 des Kühlkörpers 10. Die erste Seite 21 der Zwischenschicht 20 ist dabei der Oberseite 11 des Kühlkörpers 10 zugewandt. Durch die Zwischenschicht 20 ist die bereits in Leiterbahnabschnitte 21 untergliederte metallische Schicht 30 auf den Kühlkörper 10 auflaminiert. Die erste Seite 21 der Zwischenschicht 20 haftet in diesem Ausführungsbeispiel stoffschlüssig an der Oberseite 41 des Kühlkörpers 40 an. Die Zwischenschicht 20 ist in diesem Ausführungsbeispiel eine Laminierfolie aus Kunststoff. So ist die erste Seite 21 der Zwischenschicht 20 in diesem Ausführungsbeispiel auf die Oberseite 41 des Kühlkörpers 40 laminiert. Die Zwischenschicht 20 ist in diesem Ausführungsbeispiel einstückig ausgebildet. Die Zwischenschicht 20 kann aber beispielsweise auch mehrere nicht miteinander verbundene Bereiche umfassen. Die Zwischenschicht 20 liegt in diesem Ausführungsbeispiel mit der ersten Seite 21 direkt an der Oberseite 41 des Kühlkörpers 40 an. Die Zwischenschicht 20 liegt in diesem Ausführungsbeispiel mit der zweiten Seite 22 direkt an der Kontaktseite 32 der metallischen Schicht 30 an. Die Zwischenschicht 20 ist in diesem Ausführungsbeispiel in einer Richtung senkrecht zu der Oberseite 11 des Kühlkörpers 10 von der ersten Seite 21 bis zur zweiten Seite 22 durchgehend aus demselben Material und einstückig ausgebildet.

Das Leistungsmodul 1 umfasst weiterhin eine Lage mit einer in Leiterbahnabschnitte 31 untergliederten metallischen Schicht 30. Die in Leiterbahnabschnitte 31 untergliederte metallische Schicht 30 ist unabhängig von der Herstellung der Zwischenschicht 20 und unabhängig von der Herstellung des Kühlkörpers 10 aus wenigstens einem in Leiterbahnabschnitte 31 untergliederten Metallblech hergestellt. Zur Untergliederung des Metallblechs sind die Leiterbahnabschnitte 31 beispielsweise aus dem Metallblech herausgestanzt, so dass die Leiterbahnabschnitte 31 als Stanzteile ausgebildet sind. Somit können beispielsweise mehrere Leiterbahnabschnitte 31 aus einem Metallblech gefertigt sein, insbesondere gestanzt sein. Die Leiterbahnabschnitte 31 können aber beispielsweise auch aus mehreren Metallblechen gefertigt werden und anschließend zu der metallischen Schicht 30 zusammengesetzt werden. In diesem Ausführungsbeispiel umfasst das Leistungsmodul 1 eine Mehrzahl an Leiterbahnabschnitten 31. Es kann aber beispielsweise auch nur ein Leiterbahnabschnitt 31 vorgesehen sein. Die Leiterbahnabschnitte 31 können zumindest teilweise aus einem oder mehreren Metallen mit guter elektrischer Leitfähigkeit, wie etwa Kupfer oder Aluminium gefertigt sein.

Wie in den Figuren dargestellt sind die Leiterbahnabschnitte 31 in diesem Ausführungsbeispiel flächig ausgebildet. Die Leiterbahnabschnitte 31 erstrecken sich im Wesentlichen flächig unter Zwischenlage der Zwischenschicht 20 auf der Oberseite 11 des Kühlkörpers 10. Die Leiterbahnabschnitte 31 erstrecken sich im Wesentlichen flächig in einer gemeinsamen Erstreckungsebene E der metallischen Schicht 30. Die metallische Schicht 30, die aus den Leiterbahnabschnitten 31 gebildet wird, erstreckt sich somit im Wesentlichen in der Erstreckungsebene E. Die Leiterbahnabschnitte 31 können Anschlussbereiche 33 umfassen, die einstückig mit den Leiterbahnabschnitten 31 ausgebildet sind. Die Anschlussbereiche 33 sind zur elektrischen Kontaktierung des Leistungsmoduls 1 mit außerhalb des Leistungsmoduls 1 angeordneten und in den Figuren nicht dargestellten Komponenten wie beispielsweise einem Zwischenkreiskondensator oder einer elektrischen Maschine vorgesehen. Die Erstreckungsebene E ist in diesem Ausführungsbeispiel planparallel zu der Oberseite 11 des Kühlkörpers 10 und zu der Zwischenschicht 20 angeordnet. Der Bereich der Leiterbahnabschnitte 31, der nicht die Anschlussbereiche 33 der flächigen Leiterbahnabschnitte 31 bildet, ist somit parallel zu der Oberseite des Kühlkörpers 10 und zu der Zwischenschicht 20 angeordnet.

Die Anschlussbereiche 33 können beispielsweise außerhalb der Erstreckungsebene E der metallischen Schicht 30 angeordnet sein. So können die Leiterbahnabschnitte 31 derart geformt sein, dass die Anschlussbereiche 33 aus der Erstreckungsebene E der metallischen Schicht 30 herausragen. Beispielsweise kann ein Anschlussbereich 33 des Leiterbahnabschnittes 31 aus der Erstreckungsebene E der metallischen Schicht 30 herausgebogen sein. In diesem Ausführungsbeispiel sind die Anschlussbereiche 33 derart aus Erstreckungsebene E herausgebogen, dass sie senkrecht auf der Erstreckungsebene E der metallischen Schicht 30 stehen. Ein Anschlussbereich 33 eines Leiterbahnabschnitts 31 kann somit mit dem Bereich des Leiterbahnabschnitts 31, der sich in der Erstreckungsebene E erstreckt, ein L-förmiges Profil bilden. Die Erstreckungsebene E der metallischen Schicht 30 liegt in diesem Ausführungsbeispiel planparallel zu Oberseite 11 des Kühlkörpers 10. Mit Ausnahme der aus der Erstreckungsebene E herausgebogenen Anschlussbereiche 33 erstrecken sich somit in diesem Ausführungsbeispiel die Leiterbahnabschnitte 31 in der Erstreckungsebene E der metallischen Schicht 30.

Die metallische Schicht 30 ist auf der zweiten Seite 22 der Zwischenschicht 20 angeordnet und an der metallischen Schicht 30 ist eine Kontaktseite 32 ausgebildet, die der zweiten Seite der Zwischenschicht 20 zugewandt ist. Die Kontaktseite 32 der metallischen Schicht 30 haftet in diesem Ausführungsbeispiel stoffschlüssig an der zweiten Seite 22 der Zwischenschicht 20 kann. Die zweite Seite 22 der in diesem Ausführungsbeispiel als Laminierfolie ausgebildeten Zwischenschicht 20 ist in diesem Ausführungsbeispiel auf die Kontaktseite 32 der metallischen Schicht 30 auflaminiert.

Das Leistungsmodul 1 umfasst in diesem Ausführungsbeispiel weiterhin elektrische und/oder elektronische Leistungsbauelemente 40, die auf Leiterbahnabschnitten 31 der metallischen Schicht 30 aufgebracht sind und elektrisch mit Leiterbahnabschnitten 31 der metallischen Schicht 30 kontaktiert sind. Bei den elektrischen und/oder elektronischen Leistungsbauelement 40 kann es sich beispielsweise um Leistungshalbleiter wie beispielsweise Feldeffekttransistoren wie MIS-FETs (Metal Insulated Semiconductor Field Effect Transistor), IGBTs (insulated-gate bipolar transistor), Leistungs-MOSFETs (metal oxide semiconductor field-effect transistor) und/oder Dioden, beispielsweise Gleichrichterdioden, handeln. Es kann sich beispielsweise um gehäuselose Leistungshalbleiter (Bare-Die) handeln. Weiterhin kann das Leistungsmodul 1 auch passive Bauelemente wie beispielsweise Widerstände oder Kondensatoren umfassen. Die elektrischen und/oder elektronischen Bauelemente und/oder elektrischen und/oder elektronischen Leistungsbauelemente 40 können untereinander oder mit außerhalb des Leistungsmoduls 1 angeordneten und in den Figuren nicht dargestellten weiteren elektrischen und/oder elektronischen Elementen beispielsweise über die Leiterbahnabschnitte 31, über Bonddrähte oder andere geeignete elektrisch leitende Kontaktelemente beispielsweise durch Löten oder Sintern elektrisch leitend verbunden sein. Die Leiterbahnabschnitte 31 sind in diesem Ausführungsbeispiel als Leiterflächen ausgebildet.

Ein Verfahren, das zur Herstellung eines Leistungsmoduls 1 verwendet werden kann, umfasst beispielsweise einen Schritt in dem die metallische Schicht 30 in Leiterbahnabschnitte 31 untergliedert wird. Dies kann beispielsweise dadurch erfolgen, dass aus einem oder mehreren Metallblechen eine oder mehrere Leiterbahnabschnitte 31 gestanzt werden. Die Leiterbahnabschnitte 31 können aber beispielsweise auch durch andere Techniken aus einem oder mehreren Metallblechen gefertigt werden. Weiterhin können die Leiterbahnabschnitte 31 gebogen werden. So können die Leiterbahnabschnitte 31 beispielsweise derart gebogen werden, dass Anschlussbereiche 33 der Leiterbahnabschnitte 31 gegenüber anderen Bereichen der Leiterbahnabschnitte 31 abgewinkelt sind.

Das Verfahren zur Herstellung des Leistungsmoduls 1 umfasst weiterhin einen Schritt bei dem die in Leiterbahnabschnitte 31 untergliederte metallische Schicht 30 unter Zwischenlage der haftvermittelnden Zwischenschicht 20 auf die Oberseite 41 des Kühlkörpers 40 aufgebracht wird. In einem weiteren Schritt wird die in Leiterbahnabschnitte 31 untergliederte metallische Schicht 30 unter Zwischenlage der haftvermittelnden Zwischenschicht 20 auf den Kühlkörper 40 auflaminiert.

Das Verfahren zur Herstellung des Leistungsmoduls 1 umfasst weiterhin einen Schritt, bei dem das wenigstens eine elektrische und/oder elektronische Leistungsbauelement 40 auf die metallische Schicht 30 aufgebracht wird.

Weiterhin umfasst das Verfahren zur Herstellung des Leistungsmoduls 1 einen Schritt, bei dem das wenigstens eine elektrische und/oder elektronische Leistungsbauelement 40 mit wenigstens einem Leiterbahnabschnitt 31 der metallischen Schicht 30 elektrisch kontaktiert wird.

## Patentansprüche

1. Leistungsmodul (1), umfassend wenigstens drei übereinander gestapelte Lagen, darunter:
- wenigstens ein Kühlkörper (10) mit einer Oberseite (11),
- wenigstens eine auf die Oberseite (11) des Kühlkörpers (10) aufgebrachte und sich flächig erstreckende haftvermittelnde Zwischenschicht (20) mit einer der Oberseite (11) des Kühlkörpers (10) zugewandten ersten Seite (21) und einer von der ersten Seite (21) abgewandten zweiten Seite (22),
- wenigstens eine auf der zweiten Seite (22) der Zwischenschicht (20) angeordnete in Leiterbahnabschnitte (31) untergliederte metallische Schicht (30) mit einer Kontaktseite (32), die der zweiten Seite (22) der Zwischenschicht (20) zugewandt ist,
wobei das Leistungsmodul (1) weiterhin wenigstens ein elektrisches und/oder elektronisches Leistungsbauelement (40) umfasst, das auf wenigstens einen Leiterbahnabschnitt (31) der metallischen Schicht (30) aufgebracht ist und elektrisch mit dem wenigstens einen Leiterbahnabschnitt (31) der metallischen Schicht (30) kontaktiert ist,
wobei die in Leiterbahnabschnitte (31) untergliederte metallische Schicht (30) unabhängig von der Herstellung der Zwischenschicht (20) und unabhängig von der Herstellung des Kühlkörpers (10) aus wenigstens einem in Leiterbahnabschnitte (31) untergliederten Metallblech hergestellt ist,
**dadurch gekennzeichnet, dass** die erste Seite (21) der Zwischenschicht (20) auf die Oberseite (11) des Kühlkörpers (10) laminiert ist und dass die zweite Seite (22) der Zwischenschicht (20) auf die Kontaktseite (32) der metallischen Schicht (30) laminiert ist, wobei die Zwischenschicht (20) als Laminierfolie aus Kunststoff ausgebildet ist.

2. Leistungsmodul nach Anspruch 1, **dadurch gekennzeichnet, dass** die erste Seite (21) der Zwischenschicht (20) stoffschlüssig an der Oberseite (11) des Kühlkörpers (10) anhaftet und/oder dass die zweite Seite (22) der Zwischenschicht (20) stoffschlüssig der Kontaktseite (32) der metallischen Schicht (30) anhaftet.

3. Leistungsmodul nach einem der vorhergehenden Ansprüche, **dadurch gekennzeichnet, dass** die Leiterbahnabschnitte (31) als Stanzteile ausgebildet sind.

4. Leistungsmodul nach einem der vorhergehenden Ansprüche, **dadurch gekennzeichnet, dass** der Leiterbahnabschnitt (31) zumindest einen Anschlussbereich (33) zur elektrischen Kontaktierung des Leiterbahnabschnitts (31) aufweist, wobei der Anschlussbereich (33) außerhalb einer Erstreckungsebene (E) der metallischen Schicht (30) angeordnet ist, in der sich die metallische Schicht (30) im Wesentlichen erstreckt.

5. Leistungsmodul nach Anspruch 4, **dadurch gekennzeichnet, dass** der Anschlussbereich (33) des Leiterbahnabschnittes (31) aus der Erstreckungsebene (E) des Leiterbahnabschnitts (31) herausgebogen ist.

6. Leistungsmodul nach einem der vorhergehenden Ansprüche, **dadurch gekennzeichnet, dass** die Zwischenschicht (20) einstückig ausgebildet ist und dass die Zwischenschicht (20) mit der ersten Seite (21) direkt an der Oberseite (11) des Kühlkörpers (10) anliegt und die Zwischenschicht (20) mit der zweiten Seite (22) direkt an der Kontaktseite (32) der metallischen Schicht (30) anliegt.

7. Verfahren zur Herstellung eines Leistungsmoduls (1) nach einem der Ansprüche 1 bis 6, wobei das Verfahren folgende Schritte umfasst:
- Herstellung einer in Leiterbahnabschnitte (31) untergliederten metallischen Schicht (30) aus wenigstens einem Metallblech,
- Aufbringen der in Leiterbahnabschnitte (31) untergliederten metallischen Schicht (30) unter Zwischenlage einer haftvermittelnden Zwischenschicht (20) auf die Oberseite (11) des Kühlkörpers (10),
- Auflaminieren der in Leiterbahnabschnitte (31) untergliederten metallischen Schicht (30) unter Zwischenlage der haftvermittelnden Zwischenschicht (20) auf den Kühlkörper (40)
- Aufbringen wenigstens eines elektronischen Leistungsbauelement (40) auf wenigstens einen Leiterbahnabschnitt (31) der metallischen Schicht (30)
- Elektrische Kontaktierung des elektronischen Leistungsbauelement (40) mit dem wenigstens einen Leiterbahnabschnitt (31) der metallischen Schicht (30).

## Claims

1. Power module (1) comprising at least three layers that are stacked one above the other, including:
- at least one cooling body (10) having an upper face (11),
- at least one intermediate layer (20) that is applied to the upper face (11) of the cooling body (10) and extends in a planar manner and provides an adhesive bond and comprises a first face (21) that is facing the upper face (11) of the cooling body (10) and a second face (22) that is remote from the first face (21),
- at least one metal layer (30) that is arranged on the second face (22) of the intermediate layer (20) and is sub-divided into conductor track sections (31) and comprises a contact face (32) that faces the second face (22) of the intermediate layer (20),
wherein the power module (1) furthermore comprises at least one electric and/or electronic power component (40) that is applied to at least one conductor track section (31) of the metal layer (30) and is in electrical contact with the at least one conductor track section (31) of the metal layer (30),
wherein the metal layer (30) that is sub-divided into conductor track sections (31) is produced from at least one metal sheet, which is sub-divided into conductor track sections (31), independently from the production of the intermediate layer (20) and independently from the production of the cooling body (10),
**characterized in that** the first face (21) of the intermediate layer (20) is laminated to the upper face (11) of the cooling body (10) and **in that** the second face (22) of the intermediate layer (20) is laminated to the contact face (32) of the metal layer (30), wherein the intermediate layer (20) is configured as a laminating film that is embodied from a synthetic material.

2. Power module according to Claim 1, **characterized in that** the first face (21) of the intermediate layer (20) adheres in a bonded manner to the upper face (11) of the cooling body (10) and/or **in that** the second face (22) of the intermediate layer (20) adheres in a bonded manner to the contact face (32) of the metal layer (30).

3. Power module according to either one of the preceding claims, **characterized in that** the conductor track sections (31) are configured as stamped parts.

4. Power module according to any one of the preceding claims, **characterized in that** the conductor track section (31) comprises at least one connection region (33) so as to electrically contact the conductor track section (31), wherein the connection region (33) is arranged outside an extension plane (E) of the metal layer (30) in which the metal layer (30) essentially extends.

5. Power module according to Claim 4, **characterized in that** the connection region (33) of the conductor track section (31) is bent out of the extension plane (E) of the conductor track section (31).

6. Power module according to any one of the preceding claims, **characterized in that** the intermediate layer (20) is configured as one piece and **in that** the intermediate layer (20) lies with the first face (21) directly against the upper face (11) of the cooling body (10) and the intermediate layer (20) lies with the second face (22) directly against the contact face (32) of the metal layer (30) .

7. Method for producing a power module (1) according to any one of Claims 1 to 6, wherein the method comprises the following steps:
- producing a metal layer (30) that is sub-divided into conductor track sections (31) and is configured from at least one metal sheet,
- applying the metal layer (30) that is sub-divided into conductor track sections (31) to the upper face (11) of the cooling body (10) by interpositioning an intermediate layer (20) that provides an adhesive bond,
- laminating the metal layer (30) that is sub-divided into conductor track sections (31) to the cooling body (40) by interpositioning an intermediate layer (20) that provides an adhesive bond,
- attaching at least one electronic power component (40) to at least one conductor track section (31) of the metal layer (30) and
- providing electrical contact between the electronic power component (40) and the at least one conductor track section (31) of the metal layer (30).

## Revendications

1. Module de puissance (1), comprenant au moins trois couches empilées les unes sur les autres, dont :
- au moins un dissipateur thermique (10) pourvu d'une face supérieure (11),
- au moins une couche intermédiaire favorisant l'adhérence (20) qui est appliquée sur la face supérieure (11) du dissipateur thermique (10), qui s'étend de manière bidimensionnelle et qui comporte une première face (21) dirigée vers la face supérieure (11) du dissipateur thermique (10) et une deuxième face (22) dirigée à l'opposé de la première face (21),
- au moins une couche métallique (30) disposée sur la deuxième face (22) de la couche intermédiaire (20), subdivisée en portions de piste conductrice (31) et pourvue d'une face de contact (32) qui est dirigée vers la deuxième face (22) de la couche intermédiaire (20), le module de puissance (1) comprenant en outre au moins un composant de puissance électrique et/ou électronique (40) qui est appliqué sur au moins une portion de piste conductrice (31) de la couche métallique (30) et qui est en contact électrique avec l'au moins une portion de piste conductrice (31) de la couche métallique (30), la couche métallique (30) subdivisée en portions de piste conductrice (31) étant réalisée à partir d'au moins une tôle métallique subdivisée en portions de piste conductrice (31) indépendamment de la réalisation de la couche intermédiaire (20) et indépendamment de la réalisation du dissipateur thermique (10),
**caractérisé en ce que** la première face (21) de la couche intermédiaire (20) est stratifiée sur la face supérieure (11) du dissipateur thermique (10) et **en ce que** la deuxième face (22) de la couche intermédiaire (20) est stratifiée sur la face de contact (32) de la couche métallique (30), la couche intermédiaire (20) étant conçue comme un film de stratification en matière synthétique.

2. Module de puissance selon la revendication 1, **caractérisé en ce que** la première face (21) de la couche intermédiaire (20) adhère à la face supérieure (11) du dissipateur thermique (10) par une liaison de matière et/ou **en ce que** la deuxième face (22) de la couche intermédiaire (20) adhère à la face de contact (32) de la couche métallique (30) par une liaison de matière.

3. Module de puissance selon l'une des revendications précédentes, **caractérisé en ce que** les portions de piste conductrice (31) sont réalisées sous la forme de pièces embouties.

4. Module de puissance selon l'une des revendications précédentes, **caractérisé en ce que** la portion de piste conductrice (31) comporte au moins une zone de connexion (33) destinée à établir un contact électrique avec la portion de piste conductrice (31), la zone de connexion (33) étant disposée à l'extérieur d'un plan d'extension (E) de la couche métallique (30) dans lequel s'étend sensiblement la couche métallique (30).

5. Module de puissance selon la revendication 4, **caractérisé en ce que** la zone de connexion (33) de la portion de piste conductrice (31) est coudée hors du plan d'extension (E) de la portion de piste conductrice (31) .

6. Module de puissance selon l'une des revendications précédentes, **caractérisé en ce que** la couche intermédiaire (20) est formée d'une seule pièce et **en ce que** la couche intermédiaire (20) est en appui, avec la première face (21), directement sur la face supérieure (11) du dissipateur thermique (10) et la couche intermédiaire (20) est en appui, avec la deuxième face (22), directement sur la face de contact (32) de la couche métallique (30).

7. Procédé de réalisation d'un module de puissance (1) selon l'une des revendications 1 à 6, le procédé comprenant les étapes suivantes :
- réaliser une couche métallique (30), subdivisée en portions de piste conductrice (31), à partir d'au moins une tôle métallique,
- appliquer la couche métallique (30), subdivisée en portions de piste conductrice (31), sur la face supérieure (11) du dissipateur thermique (10) avec interposition d'une couche intermédiaire (20) favorisant l'adhérence,
- laminer la couche métallique (30), subdivisée en portions de piste conductrice (31), sur le dissipateur thermique (40) avec interposition de la couche intermédiaire (20) favorisant l'adhérence,
- appliquer au moins un composant de puissance électronique (40) sur au moins une portion de piste conductrice (31) de la couche métallique (30),
- établir un contact électrique entre le composant de puissance électronique (40) et l'au moins une portion de piste conductrice (31) de la couche métallique (30).
